# EUROPEAN PATENT SPECIFICATION

(11) **EP 1 909 959 B1**
(45) Date of publication and mention of the grant of the patent: **11.01.2012**
(21) Application number: 06729729.1
(22) Date of filing: 16.03.2006
(51) Int. Cl.: B01L 3/00, B01D 71/02

(54) **PILLAR STRUCTURE FOR SEPARATING OR CAPTURING TARGET SUBSTANCE**
SÄULENSTRUKTUR ZUM TRENNEN ODER AUFNEHMEN EINER ZIELSUBSTANZ
STRUCTURE AVEC PILIERS POUR SEPARER OU CAPTURER UNE SUBSTANCE CIBLE

(30) Priority: 18.03.2005 JP 2005079956
(43) Date of publication of application: 16.04.2008
(73) Proprietor: CANON KABUSHIKI KAISHA, Ohta-ku Tokyo 146-8501 (JP)
(72) Inventor: YAMAMICHI, Junta, c/o CANON KABUSHIKI KAISHA, Tokyo 146-8501 (JP); OGAWA, Miki, c/o CANON KABUSHIKI KAISHA, Tokyo 146-8501 (JP); NAKANISHI, Kazuki, c/o Kyoto University, Sakyo-ku, Kyoto-shi, Kyoto 606-8502 (JP)
(74) Representative: Weser, Thilo
(86) International application number: PCT/JP2006/305762
(87) International publication number: WO 2006/098502

(56) References cited:
- EP-A- 1 413 346
- EP-A- 1 416 303
- WO-A-03/010289
- WO-A-2004/051228
- WO-A-2004/051231
- US-A1- 2003 049 563
- US-A1- 2004 209 392

## Description

### TECHNICAL FIELD

The present invention relates to a structure for separating or capturing a specified substance and a producing method therefor, and a separating element, a capturing element, a separating apparatus, and a detecting apparatus utilizing such structure.

### BACKGROUND ART

For analyzing a protein or nucleic acid of a trace amount, there have been used apparatus utilizing electrophoresis or liquid chromatography, as represented by capillary electrophoresis or capillary liquid chromatography. Such apparatus perform an analysis by filling a glass capillary of an internal diameter of 100 µm or less with a separating matrix. Such analysis utilizing a microspace has provided an improved efficiency. Based on such situation, it is now being proposed to utilize, instead of a microspace in the order of 100 µm, a microspace in the order of 10 µm or less.

For such purpose, there is already known a method of utilizing a porous member for example a microfilter such as a nitrocellulose membrane or a nylon membrane, a paper, a non-woven cloth or a yarn as a matrix, and a method of filling a reactor with beads to form a porous member. Such a porous member has an effective surface area much larger than an apparent surface area, thus being capable of fixing or carrying many captured components or interacting components on the surface.

However, such matrix is considered to contain, because of its structure, many closed spaces which the target substance cannot reach. Such space becomes a wasted space which cannot contribute to the reaction, with respect to the volume of the matrix, thus deteriorating the separating ability as a separating element or the efficiency as a capturing element. Also in the bead filling method, when a solution to be inspected is injected and pressurized in a micro flow path over a long time or in a large amount, the beads themselves are moved to induce clogging, or the filled structure varies depending on the filling method and is not well reproducible.

On the other hand, biosensors and biochips are being investigated as a measuring device utilizing an excellent biomolecule-recognizing ability of a biological substance or a biomolecule, and wide applications are anticipated not only in medical fields but also in the fields of ecology, foods and the like.

In general, a biosensor is constituted of a capturing element which recognizes and captures a substance to be measured (hereinafter called target substance), and a detecting element detecting a resulting physical or chemical change and converting it into a detectable signal such as an electrical signal or an optical signal. There are known combinations of substances in living organisms showing mutual affinity, such as enzyme-substrate, antigen-antibody or DNA-DNA, and the biosensor utilizes a principle of fixing or carrying either of such combination on a matrix and utilizing it as a capturing component, thereby selectively measuring the other substance. Also the detecting element is proposed in various types such as an oxygen electrode, a hydrogen peroxide electrode, an ion electrode, an ISFET (ion sensitive field effect transistor), an optical fiber or a thermistor. Also there is recently utilized a quartz oscillator, a SAW (surface acoustic wave) element or a plasmon resonance element, capable of detecting a mass change in the order of a nano gram.

Recently investigations are actively made for a microanalysis system, which integrates such chemical analysis system on a glass or plastic substrate for example of several centimeters in square. For example, investigations are being made for a chip incorporating a very fine groove with an internal diameter of several hundred micrometers, namely a microspace, for supplying a liquid containing a reactive substance into the interior of a chip.

Such microspace has advantages that:
(1) a narrow space can reduce a time required for diffusion of substance;
(2) a large specific surface area with respect to a specimen volume enables a prompt chemical process, utilizing an interface;
(3) a small heat capacity enables a rapid temperature change; and
(4) a reduced sample amount and energy required for analysis realizes a compact system,
and a shorter period and a high precision of measurement are being tried through a scale reduction.

Also the biosensor is desired in a small apparatus which is portable or can be installed in any place and which can execute an advanced analysis within a short time, and realization of a microanalysis system is an important target. Particularly in a capturing element, use of the aforementioned microspace is important and has an important effect. It is anticipated that a biosensor of a high sensitivity and a high precision can be obtained by applying, to the capturing element, a microspace capable of fixing or carrying a capturing component at a high concentration on a matrix and also of realizing smooth contact and recognition of the target substance by such capturing component.

Among these, it is investigated to use pillar-like members, provided on a base plate, as a column for chromatography. For example, Analytical Chemistry, 2003, 75, p6244 reports a theoretical software analysis in case a conventional filled column is replaced by a column constituted of a regular array of porous pillars, and concludes that a column constituted of a regular array of porous pillars realizes a compacter column and a low separating impedance.

Separately, US2004/0125266A1 (corresponding to Japanese Patent Application Laid-open No. 2004-170935) proposes a functional substrate, applicable to a molecular filter, a biochip or an optical device, formed by positioning pillar-like projections of an organic polymer on an organic polymer base plate. The reference states that the functional substrate can be prepared inexpensively by pressing, as the pillar-like projections are constituted of an organic polymer.

Also apart from such pillars, Japanese Patent Application Laid-open No. 2004-99418 discloses use of porous gel as a separating medium, applicable to the analysis of cellular chemical substances such as nucleic acid or proteins. An invention described in the reference intends to provide a material formed by covering a gel skeleton, having macropores, with an oxide layer matching a compound to be separated.

More specifically, it discloses a producing method for a porous material of preparing a porous gel by sol-gel transition involving phase separation, then introducing a substance constituting a precursor of a metal oxide in such porous material, and forming a covering'metal oxide layer by a hydrolysis-polycondensation reaction. The invention in this reference reports to obtain a material which can pass a solution with a pressure lower than in a filled column.

However, Analytical Chemistry, 2003, 75, p6244 mentioned above merely shows a theoretical analysis, and does not include detailed specific disclosure on the material and producing method of the porous pillars.

Also in US2004/0125266A1, the pillar-like projections are formed with an organic polymer, and a molecule containing a corrosive component captured on the pillar-like projection may deteriorate the stability of the organic polymer. Also the base plate on which the pillar-like projections are formed is formed by a material same as the organic polymer constituting such pillar-like projections, thus imposing a restriction in forming the pillar-like projections thereon and leading to an increased cost.

Further, Japanese Patent Application Laid-open discloses a separating medium utilizing a porous gel, which however does not utilize a pillar-like structure and a further improvement is desired for a separating medium of a lower flow resistance.

US 2003/0049563 A discloses a fractionating apparatus to be used for fractionating a sample into micro-structures different in size, said apparatus including a fractionating unit formed with a fractionating passage defined in a groove formed in a substrate of the fractionating unit.

### DISCLOSURE OF THE INVENTION

An object of the present invention is to provide an inexpensive structure having a low flow resistance and capable of stably separating or capturing a specified substance. Another object of the present invention is to provide a separating element, a separating apparatus, a capturing element and a detecting apparatus, utilizing a structure thus obtained. Still another object of the present invention is to provide a separating apparatus and a detecting apparatus, having an excellent light transmittance and applicable to an optical detection.

A structure provided by the present invention has an opening communicating with an inner space and is adapted for separating or capturing a substance introduced from the opening into the inner space, and it comprises a hollow member having the inner space and the opening, and plural pillars positioned mutually separately in the inner space, wherein the pillars are formed of a material containing an inorganic oxide and different in composition from the hollow member.

A separating element of the present invention, having an opening communicating with an inner space, adapted for separating a target substance contained in a specimen introduced from the opening into the inner space, comprises the structure mentioned above and a separating component, provided on a surface of the pillars, capable of having an interaction with the target substance to thereby perform separation of the target substance from the specimen.

A separating apparatus of the present invention, adapted for separating a target substance contained in a specimen, comprises the separating element mentioned above, and fluid displacement means which causes fluid displacement within the inner space of the separating element.

A capturing element of the present invention, having an opening communicating with an inner space, adapted for capturing a target substance contained in a specimen introduced from the opening into the inner space, comprises the structure mentioned above and a capturing component, provided on a surface of the pillars, capable of capturing the target substance.

A target substance detecting apparatus of the present invention comprises the capturing element mentioned above, and detecting means for detecting that the target substance is captured by the capturing element.

A method for separating a target substance contained in a specimen of the present invention comprises a step of contacting the specimen with the separating element mentioned above, and a step of separating the target substance from the specimen, utilizing a physical or chemical interaction of the separating element with the target substance, the interaction being caused to occur in the contacting step.

A target substance detecting method for detecting a target substance contained in a specimen of the present invention comprises a step of contacting the specimen with the capturing element mentioned above, and a step of detecting a physical or chemical change resulting from a capture of the target substance by the capturing element.

A method for producing a structure provided, in a hollow member having an inner space, with pillars in the inner space, comprises a step of preparing a reaction solution dissolving an inorganic oxide precursor and having a composition regulated to form the pillars, a step of introducing the reaction solution to fill the inner space, and a step of inducing phase separation and sol-gel transition in the inner space to thereby form the pillars in a direction parallel to the gravitational direction.

The structure of the present invention is applicable to a separating element such as a chromatographic column. In the structure of the present invention, the plural pillars provided in the hollow member having the inner space, being formed by a material containing an inorganic oxide, can show a stable separating or capturing function even for a corrosive substance. Also since the hollow member having the inner space and the pillars are formed by materials of different compositions, an inexpensive material may be selected for the hollow member having the inner space while maintaining characteristics such as strength of the pillars, whereby the structure can be prepared from various materials.

The present invention can inexpensively provide a structure having a low flow resistance and capable of stably separating or capturing a specified substance. Also the structure of the present invention can be used for providing a separating element, a separating apparatus, a capturing element or a detecting apparatus. Also there can be provided a detecting apparatus having an excellent light transmittance, and capable of applying an optical method for the detection of the target substance and capable of detection of a high sensitivity.

### BRIEF DESCRIPTION OF THE DRAWINGS

Figs. 1A and 1B are schematic cross-sectional views of a structure of the present invention.
Figs. 2A, 2B, 2C and 2D are schematic views showing examples of a structure having a microspace surrounded by a wall.
Fig. 3 is a schematic cross-sectional view of a structure in which pillars are formed in a part of a microspace.
Fig. 4 is a schematic view showing a capturing element according to Example 8.
Fig. 5 is a block diagram of an apparatus utilizing the capturing element of Example 8.
Fig. 6 is a schematic view showing a capturing element according to Example 9.
Fig. 7 is a schematic view showing a capturing element according to Example 10.
Fig. 8 is a schematic view showing an optical system of an SPR sensor.

### BEST MODES FOR CARRYING OUT THE INVENTION

A structure of the present invention has an opening communicating with an inner space and is adapted for separating or capturing a substance introduced through the opening, and it includes a hollow member having the inner space and the opening, and plural pillars positioned mutually separately in the inner space, wherein the pillar is formed by a material containing an inorganic oxide and different in composition from the hollow member.

The inorganic oxide is preferably silica, and the pillars preferably contain carbon.

A substance constituting the object of separation or capture by the structure of the present invention is not particularly restricted, but is preferably selected from organic compounds and phosphoric acid compounds. Examples of such substance include biological substances contained in an organism such as proteins, nucleic acids, sugars, peptides, amino acids, vitamins, or lipids, also related substances thereof, allergens, bacteria, viruses, and artificially synthesized pseudo biological substances. Examples also include substances constituting various plastics, fibers, paints, toners and the like, water-soluble specimens such as a plating solution or an etching solution, and substances constituting functional materials such as liquid crystals or photosensitive materials.

A separating element of the present invention, for separating a target substance in a specimen, is provided, on the surface of the pillars in the structure of the above-described structure, with a component capable of having a physical or chemical interaction with the target substance to be separated. A separating apparatus for the target substance can be constructed by employing at least such a separating element, and fluid displacing means which enables a fluid displacement in the inner space of the separating element, in which plural pillars are provided. Such a separating apparatus may further include detection means for detecting a separated state of the target substance, and such detection means is preferably optical detection means.

The structure of the above-described structure can be advantageously utilized, by providing a target substance capturing component on the surface of the pillars, as a capturing element for capturing a target substance in a specimen. A detecting apparatus can be constructed by employing at least such capturing element, and detection means for detecting a captured state, in the capturing element, of the target substance of the specimen. The detection means is preferably optical detection means. More preferable is detection means utilizing at least one selected from a fluorescence method, a luminescence method, a light absorption method, a refractive index method, a thermal conductivity method, a thermal lens method, a chemiluminescence method and a plasmon resonance method.

A target substance separating method utilizing the separating element includes at least a step of contacting the specimen with the separating element, and a step of separating the target substance, utilizing a physical or chemical interaction of the separating element and the target substance, generated in the contacting step.

Also a target substance detecting method utilizing the capturing element of the above-described constitution at least includes a step of contacting the specimen with the capturing element, and a step of detecting a physical or chemical change, generated by the contacting step.

Also a producing method for the structure of the present invention includes at least a step of dissolving an inorganic oxide precursor in a solvent to prepare a reaction solution, a step of filling the inner space of the hollow member with the reaction solution, and a step of inducing a phase separation and a sol-gel transition in the inner space thereby forming pillars. The inorganic oxide precursor is preferably a metal alcoxide, more preferably a silicon alcoxide.

In the following, preferred embodiments of the present invention will be described in further details.

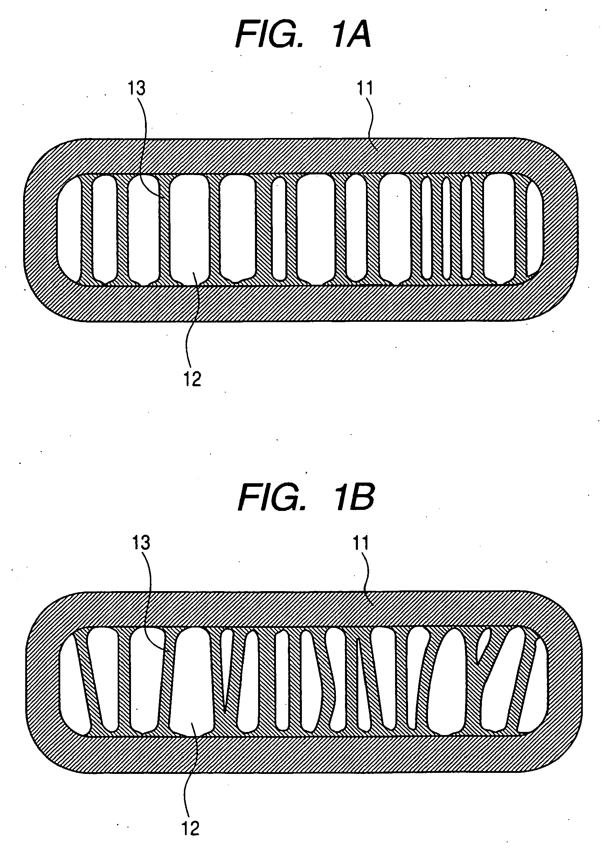

Structure of the present invention is shown in Figs. 1A and 1B. The structure shown in Figs. 1A and 1B have plural pillars 13 in a hollow member 11 including an inner space 12. In the following, constituent parts of the structure will be explained further.

### (Hollow member having inner space)

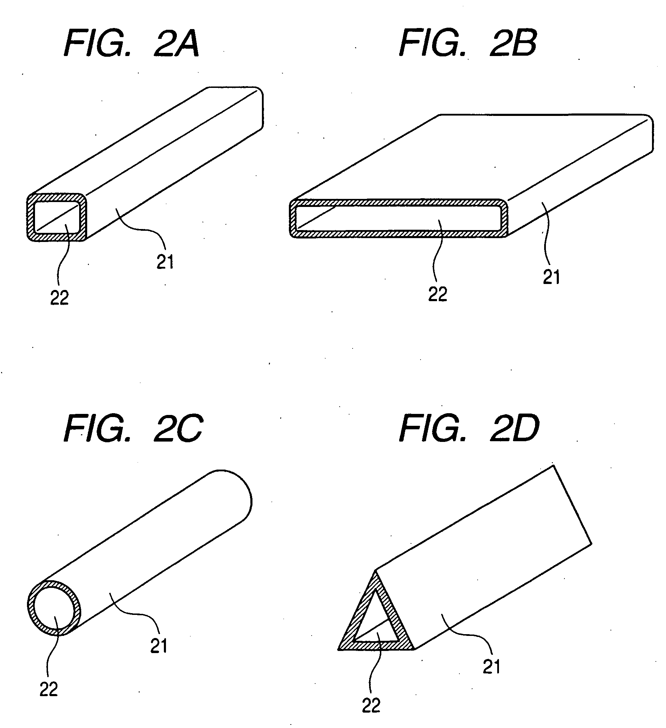

The structure of the present invention has a hollow member 21 having an inner space 22 as shown in Figs. 2A, 2B, 2C and 2D, but the hollow member employed in the present invention is not limited to such shapes as long as it has an inner space and an opening communicating therewith. However, in order to form the plural pillars in more parallel manner, two inner faces of the hollow member having the inner space are preferably parallel. In the examples shown in Figs. 2A to 2D, those shown in Figs. 2A and 2B are easier to form parallel pillars, in comparison with those shown in Figs. 2C and 2D. In the present invention, an integral hollow member in which a wall surrounding the inner space is formed continuously can be employed advantageously, but a hollow member may also be formed by adjoining an upper substrate to a flow trough or the like or by adjoining an upper substrate and a lower substrate with a spacer constituting a side wall. However, the hollow member preferably has an opening for introducing a reaction solution to fill the inner space, at least at the time of filling, in a producing method to be explained later. Examples include a microtube and a glass capillary, but any member capable of containing the reaction solution in the inner space to form pillars in the inner space may be employed without restriction, and the material and the shape can also be selected suitably. Also in case, as in the capturing element, the target substance is detected in a state captured by the capturing element, it is preferable to form at least a part of the hollow member as a light-transmissive area to be used for the detection of the target substance, for the purpose of utilizing an optical detection. For example, the entire hollow member may be formed with a light-transmissive material such as glass, thereby enabling detection with optical detecting means.

Also the inner space preferably has a size of 100 nm - 1 mm, in consideration of liquid flow at a practical speed and of uniformity of generated pillar structure. In an inner space smaller than 100 nm, the pillar structure formation by a phase separation will be difficult, while in an inner space larger than 1 mm it will be difficult to avoid deformation or unevenness in the pillar structure because of the influence of gravity. For example, in case the hollow member has a tubular form with a circular cross section (cross section perpendicular to the direction of liquid flow), the internal diameter thereof is preferably selected within the above-mentioned range. Also in case the tubular hollow member has a triangular or tetragonal cross section, the length of the shortest side or the longitudinal size of pillars to be formed is preferably within the aforementioned range.

### (Pillar)

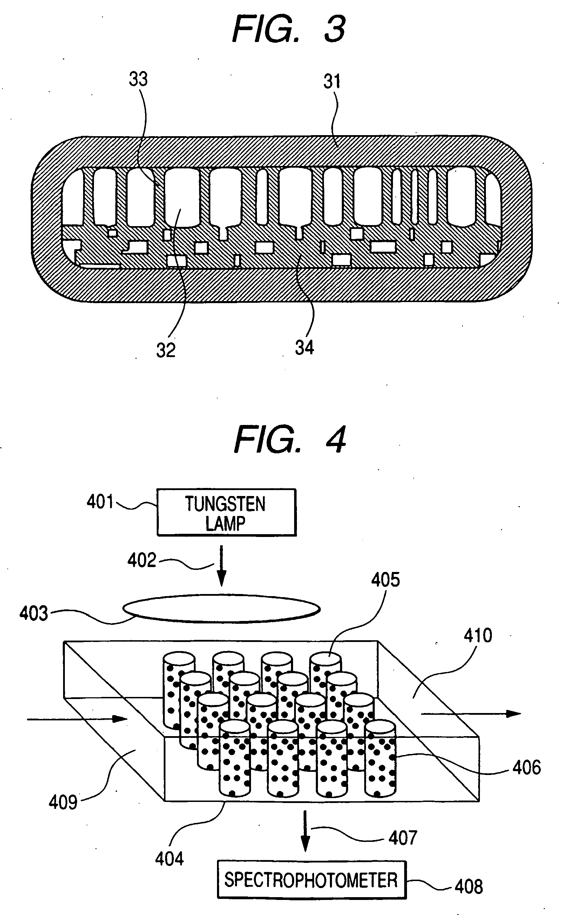

The structure of the present invention has, in the aforementioned inner space, plural pillars 13 as shown in Figs. 1A and 1B. Each pillar extends in the inner space 12, from a base portion on an inner wall of the hollow member 11 and is bonded at the other end also to an internal wall of the inner space. The structure of the present invention has a plurality of pillars having a structure adjoined at both ends to the upper and lower inner walls, but may also includes a pillar of a structure fixed at one end only to the upper or lower inner wall and not reaching the lower or upper inner wall at the other end. Also the pillars may be formed in a part of the inner space, and the effect of the present invention is not deteriorated even in case, as shown in Fig. 3, the inner space 32 of a hollow member 31 includes both pillars 33 and a three-dimensional network porous region (three-dimensional network structure) 34. The pillars in the present invention have a diameter of 100 nm - 1 mm, and are arranged with a gap of 100 nm - 1 mm. The height of pillars is influenced by the size of the hollow member with the inner space, but is preferably in a range of 100 nm - 1 mm. The cross-sectional shape of pillars is generally circular or oval, but may also be a modified shape thereof. A longitudinal cross-sectional shape is generally rectangular or square, or also a rectangular shape of which an upper or lower part is wider than in the center, but may also be a modified shape thereof. Also the pillars represent a volumic proportion in the inner space of 94 % or less in consideration of the producing method. However, for achieving a high specific surface area and a low flow resistance, in order to be advantageously applicable to a separating element or a capturing element, the volumic proportion is preferably 50 % or less and more preferably 10 - 50 %. The pillars may be positioned in various arrangements, but, for reducing the flow resistance for a fluid, in a regular arrangement in which plural pillars are positioned substantially in a matrix pattern, as in the case of pillars 405 shown in Fig. 4.

Such fine structure can be formed by utilizing phase separation and sol-gel transition, generated in a process in which the inorganic oxide precursor undergoes hydrolysis/polycondensation reaction.

The material constituting the pillars includes inorganic oxides such as silica, alumina or titania. In the present invention, the material constituting the pillars is not particularly restricted as long as it has a composition different from that of the material constituting the hollow member having the inner space, but preferably includes silica, in consideration of chemical resistance, mechanical strength and the ease of carrying an interacting component or a capturing component to be explained later.

In the present invention, the material constituting the pillars and the material constituting the hollow member having an inner space have different compositions of material. Having different compositions means not only cases where the materials have the same constituent elements but are different in composition, but also cases where the materials have different constituent elements, namely where the hollow member having an inner space and the pillars are formed by different materials. Also for structural control at the pillar formation, the pillars are preferably formed including carbon such as an alkyl group.

In the present invention, as will be explained later in the producing method, the hollow member having an inner space and the pillars are formed with materials of different compositions. It is therefore rendered possible, for example, to employ an inexpensive material for the hollow member having an inner space while maintaining characteristics of the pillars such as strength. Restriction in production is thus reduced in comparison with cases where the hollow member and the pillars are formed by the same material such as an organic polymer, thus allowing to provide an inexpensive structure.

In the following, a separating element of the present invention will be explained.

### (Separating element)

The separating element of the present invention is characterized in having, on a surface of the pillars provided in the structure, a component capable of having interaction (hereinafter referred to as interacting component) physically or chemically with a target substance. The separating element of the present invention is usable, for example, as a capillary column for chromatography, and, in this case, the pillar surface constitutes a stationary phase in the chromatography. The separating element of the present invention, having plural fine pillars arranged with a small gap, can increase the specific surface area and reduce the diffusion distance of the target substance in a specimen to the stationary phase. Also the low flow resistance can improve the liquid supplying property.

### (Component interacting with target substance)

The target substance separating component in the invention, capable of having physical or chemical interaction with the target substance, can be a hydrophobic component, a hydrophilic component, a component having an adsorbing ability, or a component having an ion exchange ability, but such examples are not restrictive. Such a component can be carried on the pillar surface, by being contained in advance in an inorganic oxide precursor to be explained later in the producing method. It can also be introduced, after the pillars are formed, by a reaction of a surface modifying agent. For example, in case silica is employed as the inorganic oxide, a silanol group is exposed on the surface and can be reacted with a surface modifying agent such as a silane coupling agent, having a component interacting with the target substance. The surface modifying agent can be suitably selected so as to obtain a desired surface (interacting) property, and, for example, a component having an octadecyl group can improve the hydrophobicity of the stationary phase. Also in order to reduce unnecessary interaction, a capping treatment may be applied on the excessive silanol group.

In the following, a separating apparatus of the present invention will be explained.

### (Separating apparatus)

A separating apparatus of the present invention is characterized in including the aforementioned separating element and fluid displacement means. An ordinary capillary column for chromatography has a three-dimensional network structure in a capillary, and performs separation of a substance, utilizing a difference of a surface thereof in a physical or chemical interaction. A high flow rate necessitates an increased pressure for liquid supply, thus requiring a high-performance pump system. The separating apparatus, utilizing the separating element of the present invention, has a low flow resistance and can reduce the liquid supplying pressure, as the separating element has a two-dimensional pillar structure. Also having a high light-transmittance, even in case of utilizing an optical detection system such as UV-VIS, it can achieve detection of a high sensitivity and a low liquid'supply pressure while maintaining the separating ability.

In the following, a capturing element of the present invention will be explained.

### (Capturing element)

The capturing element of the present invention is characterized in having, on the surface of the pillars in the structure, a capturing component for capturing a target substance. The capturing element of the present invention, having plural fine pillars arranged with a small gap, have a large surface area and can carry a large amount of the capturing component. Also it can reduce the diffusion distance of the target substance in a specimen to the capturing component, thereby improving the efficiency as a reaction field. Also it has a high light-transmittance, thus suitable for an optical detection.

### (Capturing component)

The capturing component to be employed in the present invention is a substance involved in the selection of the target substance in a specimen. For example, it can be a substance directly reacting selectively with the target substance in the specimen (such as so-called receptor or an antibody molecule), a substance involved in the reaction with the target substance (for example a substance having a selective catalytic action on the reaction of the target substance), or a substance deactivating substances other than the target substance in the specimen. Also such a capturing component may also have a function relating to the indication of presence/absence or level of detection, for example a function of color generation by reacting with a substance released by the receptor or a residual substance. The capturing component to be employed in the present invention, though not particularly restricted, can for example be an enzyme, a sugar chain, a catalyst, an antibody, an antigen, a nucleic acid, a gene, a color-developing reagent and the like, but such examples are not restrictive.

In the following, a detecting apparatus of the present invention having the capturing element will be explained.

### (Detecting apparatus)

A biosensor is generally constituted, as explained before, of a capturing element and a detecting element. The detecting element detects and displays a reaction, resulting when the capturing element recognizes a target substance to be specified, as a change in a light, a current, a voltage, a mass or a heat amount. As the detecting element, various elements are already proposed such as an oxygen electrode, a hydrogen peroxide electrode, an ISFET, an optical fiber, a SAW, and a thermistor. The detecting apparatus of the present invention is characterized in utilizing a highly efficient capturing element, and a detecting method to be combined is not limited to these examples. However, the capturing element of the present invention, having an excellent light-transmittance, is preferably combined with an optical detecting element utilizing at least one of optical detecting methods such as a fluorescence method, a luminescence method, a light absorption method, a refractive index method, a thermal conductivity method, a thermal lens method, a chemiluminescence method and a plasmon resonance method. In case of a combination with an optical detecting element, an optical system is preferably so constructed that an incident light and an emerging light to be detected are substantially parallel to the longitudinal axis of the pillar structure.

Also the capturing component may be used in combination, and, for example, the detection apparatus may be constructed as a composite enzyme sensor, an antibody-enzyme sensor or an enzyme-bacteria hybrid sensor.

The objet of measurement for the detecting apparatus of the present invention need not necessarily be a target substance with which the capturing component reacts directly, but can be a substance measured indirectly. For example, a measurement is made possible by detecting a target substance specifically present in the object of measurement. Therefore the object of measurement is not limited to a biological substance, and a size thereof is also not limited. However the target substance is preferably a biological substance contained in an organism such as a sugar, a sugar chain, a protein, a peptide, an amino acid, an antibody, an antigen or a pseudo antigen, a vitamin, a gene, a nucleic acid, an allergen, a bacterium, a virus, a related substance thereof, and an artificially synthesized pseudo biological substance.

In the following, a separating method of the present invention will be explained.

### - (Separating method)

The separating method of the present invention will be explained for a case of employing a silica pillar structure. A silica pillar structure, including arranged pillars, is considered, in comparison with a column three-dimensionally filled with particles, as a structure having cylindrical particles arranged between parallel flat plates. However, such structure can'be retained without depending on a filling method, and a separating ability is determined by the diameter and the gap of the pillars, designed in advance. The separation is realized by that specimen molecules, dissolved in a mobile phase solution, repeat distribution with the surface of pillars constituting the stationary phase (distribution mode) as in the ordinary liquid chromatography, or that the specimen molecules cause a molecular diffusion into the pores of the pillars depending on the molecular weight (size exclusion mode). The number of theoretical plates per unit length increases as the diameter of pillars reduces, and the flow resistance of the column decreases as the distance between pillars'reduces. The number of theoretical plates shows a maximum with respect to the linear flow rate of the mobile phase, according to the ordinary *van Deemter* formula. Therefore the separating efficiency becomes a maximum at about the linear flow rate corresponding to such a maximum. Also the pillar surface requires a chemical modification, corresponding to the chemical properties of the molecule to be separated.

A substance separation in a specimen is executed by assembling the silica pillar structure, including the arranged pillars, as a column in a liquid chromatography apparatus, and by flowing a liquid specimen. The specimen can be, for example, a biological substance contained in an organism such as a protein, a nucleic acid, a sugar, a peptide, an amino acid, a vitamin or a peptide, a related substance thereof, or an artificially synthesized pseudo biological substance. The specimen can also be various plastics or fibers, a paint with complex composition, a toner, a water-soluble specimen such as a plating solution or an etching solution, or a functional material such as a liquid crystal or a photosensitive material.

In the following, a detecting method of the present invention will be explained.

### (Detecting method)

The detection is executed by preparing a detecting window in the vicinity of an exit for the specimen solution in the silica pillar structure (on-column detection), or by connecting a detecting cell to the exit for the specimen solution in the silica pillar structure. The detection may be executed by a fluorescence method, a luminescence method, a light absorption method, a refractive index method, a thermal conductivity method, a thermal lens method, a chemiluminescence method or a plasmon resonance method, but is not limited to these methods.

In the following, a producing method for the structure of the present invention will be explained.

### (Producing method)

A structure as shown in Fig. 1 can be prepared by following steps (A) - (C).

### Step (A): preparation of reaction solution

In this step, an inorganic oxide precursor is dissolved in a solvent to obtain a reaction solution. The reaction solution is required to be regulated at a compositions capable of forming the pillars. Such composition capable of forming the pillars can be selected from a composition showing a more gradual sol-gel transition, in comparison with a composition generating a three-dimensional network porous member by a sol-gel transition. The inorganic oxide precursor can be, for example, a metal alcoxide or a metal chloride. In particular, a silicon alcoxide such as tetramethoxysilane or tetraethoxysilane, or a silicon chloride such as tetrachlorosilane is advantageously employed because of easy reaction control. Also for controlling the phase separation to be explained later and controlling the viscosity of gel phase in the course of reaction, a 3- or 2-functional alcoxide having an alkyl chain, such as methyltrimethoxysilane, ethyltrimethoxysilane or dimethoxydimethylsilane, is preferably employed. Also a plurality of such different precursors may be employed in a mixture.

As the solvent, an alcohol such as methanol or ethanol is advantageously employed, but any other solvent, such as formamide, water or a mixture thereof, may be employed as long as it is capable of dissolving a raw material of the inorganic oxide and inducing the phase separation to be explained later thereby forming the pillars. Also.water is required in hydrolyzing the inorganic oxide precursor, and is preferably contained in the solvent. Also for inducing the phase separation, an additive such as a water-soluble organic polymer or a surfactant may be mixed in the reaction solution. Also an acid such as nitric acid or hydrochloric acid may be added as a catalyst to the reaction solution.

The mixing ratio of such solvent, inorganic oxide precursor, additive, catalyst and the like may be suitably regulated to control the shape of formed pillars such as diameter, gap and density, and the coexisting ratio and the shape of a three-dimensional network porous region.

Also for controlling the hydrolysis/condensation reaction in the reaction solution, it is preferable to control the time and temperature of the period to the step (B).

### Step (B): introduction of reaction solution

In this step, the reaction solution is introduced to fill the inner space of the hollow member. The introduction into the inner space can be easily achieved by immersing an end (opening portion to the inner space) of the aforementioned hollow member into the reaction solution and utilizing a capillary action, but another method may also be employed, such as pressurizing the inner space or reducing the pressure thereof thereby forcing the reaction solution into the inner space. The inner space, filled with the reaction solution, is preferably closed tightly, in order to avoid a change in the composition of the reaction solution by solvent evaporation. Such closing may be achieved by sealing the opening portion of the hollow member, or by holding the hollow member in another container and by tightly closing such container. Also for preventing the compositional change of the reaction solution in the inner space, the hollow member filled with the reaction solution is preferably held together with the remaining reaction solution in the container.

### Step (C): phase separation and sol-gel transition

This step induces phase separation and sol-gel transition in the inner space, thereby forming pillars. By maintaining the hollow member, filled with the reaction solution, in an appropriately controlled reaction condition, the inorganic oxide precursor causes a hydrolysis/condensation reaction, and can cause phase separation in the course of such reaction. The phase-separated structure can be frozen by sol-gel transition, taking place parallel to the phase separation. In the present invention, through selection of the composition and reacting conditions of the reaction solution, a phase-separated structure of pillar shape is formed in the inner space of the hollow member, and the structure is frozen by sol-gel transition. Therefore, in the step (C), the reaction conditions such as reaction time and reaction temperature are suitably determined according to the composition of the reaction, solution in the step (A). In this instance, it is also possible, by changing such reaction conditions, to control the shape of formed pillars, such as diameter, gap and density, and the coexisting ratio and the shape of the three-dimensional network porous region. However, the reaction temperature is selected within a range where the solvent of the reaction solution does not solidify nor evaporate, preferably within a range of 0 - 100°C.

After the aforementioned operation, the solvent may be removed from the inner space. The solvent removal can be performed by opening the inner space which is closed in the step (B) to evaporate the solvent. At the solvent evaporation, heating is preferably conducted to accelerate the solvent evaporation. It is also possible to conduct the heating at a higher temperature, thereby accelerating the condensation reaction and strengthen the pillars..

The steps (A) to (C) described above allow to form a structure with an inner space, having plural pillars in the inner space. In the structure of the present invention, as the pillar is formed by a material containing an inorganic oxide and different in composition from the material constituting the hollow member with the inner space, less restrictions are encountered in comparison with a case where the external space and the pillars are formed by the same material such as an organic polymer. Therefore, an inexpensive structure can be obtained.

As the pillars are formed in the direction parallel to the gravitational direction when the hollow member filled with the reaction solution is allowed to stand, so that the shape of the hollow member and the direction of maintaining the hollow member, filled with the reaction solution, are preferably selected in consideration of the direction of forming the pillars. Also in the present invention, the hollow member is not restricted in composition and can be suitably selected as long as it can be filled with the reaction solution in the inner space and can form pillars in the inner space, so that the hollow member and the pillars may have different compositions and the pillars can be given a wider design freedom.

A separating element or a capturing element can be prepared by fixing or carrying, on the surface of the pillars in the structure prepared by the above-described producing method, an interacting component capable of executing a physical or chemical interaction with a target substance, or a capturing component.

In the following, method of fixing or carrying such components will be explained.

Such interacting component or capturing component is fixed or carried on the pillars for example by covalent bonding, ion bonding or adsorption, but the method is not limited thereto as long as such component can be satisfactorily fixed or carried.

In case of using a bonding method, an interacting component or a capturing component, having a reactive group capable of directly acting on the pillar surface, may be directly reacted to form a bond. Otherwise, a bond may be formed by reacting a crosslinking material, capable of directly acting on the pillar surface, and then reacting an interacting component or a capturing component with such crosslinking material. For example, in case the inorganic oxide is silica, the interacting component or the capturing component may be bonded, utilizing a silanol group present on the surface. It is also possible to react a crosslinking material such as a silane coupling agent with the silanol group and to bond the interacting component or the capturing component with the silane coupling agent.

In case of using an adsorption method, a combination of the interacting component or the capturing component and the material of pillars may be so selected as to have an appropriate affinity. It is also possible to once modify the pillar surface to obtain a surface having an appropriate affinity and to fix the interacting component or the capturing component.

Also the separating component or the capturing component may be carried via metal particles or a thin metal film, and such method is advantageous in case'of utilizing a surface plasmon resonance for detection.

In the following, the present invention will be described further by referring to examples, but the present invention is not limited to such examples, and materials, compositions, reacting conditions and the like may be arbitrarily changed within a range capable of obtaining a structure, a separating element, a separating apparatus, a capturing element, and a detecting apparatus of equivalent functions.

### (Example 1)

This example shows a case of employing a glass capillary as the hollow member having an inner space, and using a reaction solution constituted of methanol, methyltrimethoxysilane and nitric acid to form plural pillars in the inner space, thereby preparing a structure.

At first, 1.56 ml of methanol and 1.36 ml of a 1N aqueous solution of nitric acid were mixed and agitated under cooling with ice. Then 5.0 ml of methyltrimethoxysilane was added and the mixture was agitated for 5 minutes under cooling with ice to obtain a reaction solution. This reaction solution was transferred to a closable resin container, and an end of the glass capillary was contacted with the reaction solution to fill the capillary with the reaction solution. The capillary had an inner space witch a height of 100 µm, a width of 1 mm and a length of 50 mm. Then the capillary, filled with the reaction solution,' was immersed in the reaction solution contained in the resin container, which was then closed tightly. The closed container was allowed to stand for 24 hours in an oven at 40°C, then the resin container was opened and further allowed to stand for 24 hours in an oven at 40°C. After these operations, the glass capillary was taken out from the resin container and a cross-sectional shape was observed by using a field emission scanning electron microscope (FE-SEM). It was confirmed that a plurality of pillars were formed in the inner space, in a direction parallel to the gravitational direction applied on the capillary while standing.

Through the above-described operations, methyltrimethoxysilane caused a hydrolysis/condensation reaction to form pillars of a silica-containing material in the glass capillary as shown in Fig. 3, thereby providing the structure of the invention.

### (Example 2)

This example shows a case of employing a glass capillary as the hollow member having an inner space, and using a reaction solution constituted of methanol, methyltrimethoxysilane and nitric acid to form plural pillars in the inner space, thereby preparing a structure. In comparison with Example 1, this example is different particularly in the amount of methanol. The structure of formed pillars can be changed by changing the amount of solvent as shown in this example.

At first, methanol and 1.36 ml of a 1N aqueous solution of nitric acid were mixed and agitated under cooling with ice. Three solutions were prepared by changing the amount of methanol as 1.49 ml (solution A), 1.56 ml (solution B) and 1.59 ml (solution C). Then 5.0 ml of methyltrimethoxysilane was added to each solution and the mixture was agitated for 5 minutes under cooling with ice to obtain reaction solutions A, B and C. Each of these reaction solutions was transferred to a closable resin container, and an end of the glass capillary was contacted with the reaction solution to fill the capillary with the reaction solution. The capillary had an inner space with a height of 100 µm, a width of 1 mm and a length of 50 mm. Then the capillary, filled with the reaction solution, was immersed in the reaction solution contained in the resin container, which was then closed tightly. The closed container was allowed to stand for 24 hours in an oven at 40°C, then the resin container was opened and further allowed to stand four 24 hours in an oven at 40°C. After these operations, the glass capillary was taken out from the resin container and a cross-sectional shape was observed by using a field emission scanning electron microscope (FE-SEM). It was confirmed that a plurality of pillars were formed in the inner space of the glass capillary.

Through the above-described operations, methyltrimethoxysilane caused a hydrolysis/condensation reaction to form pillars of a silica-containing material in the glass capillary, thereby providing the structure of the invention.

The height of the pillars in the capillary increased in the order of the reaction solutions A < B < C, and a three-dimensional network porous region formed at the same time decreased in the order of the reaction solutions A > B > C. In this manner, the structure of formed pillars can be changed by changing the solvent amount. Also as to the solvent, the structure of pillars can be changed not only by the solvent amount but also by changing the type of solvent, for example by employing another solvent of different polarity, or employing a mixture of plural solvents.

### (Example 3)

This example shows a case of employing a glass capillary as the hollow member having an inner space, and using a reaction solution constituted of methanol, methyltrimethoxysilane, ethyltrimethoxysilane and nitric acid to form plural pillars in the inner space, thereby preparing a structure. The present example employed two inorganic oxide precursors in a mixture. The structure of formed pillars can be changed by changing the type of the inorganic oxide precursor as shown in this example.

At first, 0.74 ml of methanol and 1.36 ml of a 1N aqueous solution of nitric acid were mixed and agitated under cooling with ice. Then 4.75 ml of methyltrimethoxysilane and 0.2791 ml of ethyltrimethoxysilane were added and the mixture was agitated for 5 minutes under cooling with ice to obtain a reaction solution. The reaction solution was transferred to a closable resin container, and an end of the glass capillary was contacted with the reaction solution to fill the capillary with the reaction solution. The capillary had an inner space with a height of 100 µm, a width of 1 mm and a length of 100 mm. Then the capillary, filled with the reaction solution, was immersed in the reaction solution contained in the resin container, which was then closed tightly. The closed container was allowed to stand for 24 hours in an oven at 40°C, then the resin container was opened and further allowed to stand for 24 hours in an oven at 40°C. After these operations, the glass capillary was taken out from the resin container and a cross-sectional shape was observed by using a field emission scanning electron microscope (FE-SEM). It was confirmed that a plurality of pillars were formed in the inner space of the glass capillary.

Through the above-described operations, methyltrimethoxysilane and ethyltrimethoxysilane caused a hydrolysis/condensation reaction to form pillars of a silica-containing material in the glass capillary, thereby providing the structure of the invention.

In comparison with Example 1, the present example provided pillars larger in diameter and height. It is therefore advantageous in increasing the strength of pillars.

In this manner, the structure of formed pillars can be changed by changing the type of the inorganic oxide precursor or by employing a mixture thereof.

### (Example 4)

This example shows a case of employing a glass capillary as the hollow member having an inner space, and a reaction solution constituted of methanol, methyltrimethoxysilane and nitric acid to form plural pillars in the inner space, thereby preparing a structure. The present example employed a lower reaction temperature in comparison with Example 1. The structure of formed pillars can be changed by changing the reaction temperature as shown in this example.

At first, 0.88 ml of methanol and 1.36 ml of a 1N aqueous solution of nitric acid were mixed and agitated under cooling with ice. Then 5.0 ml of methyltrimethoxysilane was added and the mixture was agitated for 5 minutes under cooling with ice to obtain a reaction solution.

The reaction solution was transferred to a closable resin container, and an end of the glass capillary was contacted with the reaction solution to fill the capillary with the reaction solution. The capillary had an inner space with a height of 100 µm, a width of 1 mm and a length of 50 mm. Then the capillary, filled with the reaction solution, was immersed in the reaction solution contained in the resin container, which was then closed tightly. The closed container was allowed to stand for 48 hours in an oven at 10°C, then the resin container was opened and further allowed to stand for 24 hours in an oven at 40°C. After these operations, the glass capillary was taken out from the resin container and a cross-sectional shape was observed by using a field emission scanning electron microscope (FE-SEM). It was conformed that a plurality of pillars were formed in the inner space of the glass capillary.

Through the above-described operations, methyltrimethoxysilane caused a hydrolysis/condensation reaction to form pillars of a silica-containing material in the glass capillary, thereby providing the structure of the invention.

In comparison with Example 1, the present example provided pillars larger in diameter and height. It is therefore advantageous in increasing the strength of pillars. Also because of the reaction conducted at a lower temperature, the reaction solution showed little change in composition, by for example solvent evaporation, thereby enabling stable formation of the structure.

In this manner, the structure of formed pillars can be changed by changing the reaction temperature.

### (Example 5)

This example shows a case of employing a glass capillary as the hollow member having an inner space, and using a reaction solution constituted of methanol, methyltrimethoxysilane and nitric acid to form plural pillars in the inner space, thereby preparing a structure. The present example employed a reduced amount of nitric acid, in comparison with Example 1. The structure of formed pillars can be changed by changing the amount of acid employed as a catalyst or that of water as a polar solvent as shown in this example.

At first, 1.61 ml of methanol and 1.10 ml of a 1N aqueous solution of nitric acid were mixed and agitated under cooling with ice. Then 5.0 ml of methyltrimethoxysilane was added and the mixture was agitated for 5 minutes under cooling with ice to obtain a reaction solution. The reaction solution was transferred to a closable resin container, and an end of the glass capillary was contacted with the reaction solution to fill the capillary with the reaction solution. The capillary had an inner space with a height of 100 µm, a width of 1 mm and a length of 100 mm. Then the capillary, filled with the reaction solution, was immersed in the reaction solution contained in the resin container, which was then closed tightly. The closed container was allowed to stand for 48 hours in an oven at 10°C, then the resin container was opened and further allowed to stand for 24 hours in an oven at 40°C. After these operations, the glass capillary was taken out from the resin container and a cross-sectional shape was observed by using a field emission scanning electron microscope (FE-SEM). It was confirmed that a plurality of pillars were formed in the inner space of the glass capillary.

Through the above-described operations, methyltrimethoxysilane caused a hydrolysis/condensation reaction to form pillars of a silica-containing material in the glass capillary, thereby providing the structure of the invention.

In comparison with Example 4, the present example provided the pillars smaller in diameter and larger in number per unit volume. It is therefore advantageous in increasing the surface area of the structure. In this manner, the structure of formed pillars can be changed by changing the amount of acid as a catalyst or of water as a polar solvent.

### (Example 6)

The present example shows preparation of a separating element by fixing an octadecyl group, as an interacting component with a target substance, on the structure prepared in Example 1.

At first, the structure described in Example 1 was subjected to an ODS (octadecylsilane) modification for use as a reverse-phase column (separating element). The ODS modification was effected by introducing a toluene solution, containing octadecylsilane, into the structure and allowing it to stand at 60°C, thereby chemically modifying the pillar surface with an octadecyl group. The introduction of solution is preferably performed under pressure with a pump or the like, and a method of continuous solution supply under a constant pressure or a method of supplying a fixed amount of the solution followed by standing may be adopted as long as a sufficient amount of octadecylsilane can be supplied to the pillar surface. After the reaction, excessive octadecylsilane in the structure was removed by rinsing. Also in order to render the pillar surface more non-polar, the remaining unreacted silanol group was'reacted with trimethylchlorosilane by the ordinary method (end capping), followed by rinsing.

Through these operations, there was obtained a liquid chromatography column as the separating element, in which an octadecyl group was fixed as a component interacting with a target substance.

### (Example 7)

This example shows preparation of a separating apparatus, utilizing the separating element prepared in Example 6, and protein separation using the apparatus..

Chromatography can be conducted in various modes, such as ion exchange chromatography, gel permeation chromatography, affinity chromatography and reverse-phase chromatography. In the present example, the separating element prepared in Example 6 was employed as a liquid chromatography column. The column was equilibrated with a degassed solvent, and a sample was passed with a developing solvent. The separating element of the present invention has the feature that a detecting window can be formed in the vicinity of the exit for the specimen solution from the silica pillar structure (for on-column detection), and a usual fractionating operation is not required. The eluting protein can be on-line monitored by the UV-VIS method through the detecting window, and the desired component can be recovered when it is eluted.

### (Example 8)

This example shows preparation of a capturing element, by fixing an anti-troponin antibody as a capturing component on the structure prepared in Example 1. This example shows, for realizing an advantageous combination with a detecting element for detecting a target substance by a plasmon resonance method, a case of carrying fine gold particles on the structure and fixing a capturing component on such fine gold particles.

At first, the surface of the structure described in Example 1 was subjected to amination for carrying fine gold particles. For this purpose, the pillar surface was chemically modified with amino groups by introducing an ethanol solution containing aminosilane into the structure, and allowing it to stand at a temperature of 80°C. Introduction of the solution is preferably performed under pressure with a pump or the like. In this instance, the solution may be supplied under a constant pressure, or a fixed amount of the solution may be supplied and then allowed to stand for some time, as long as a sufficient amount of aminosilane can be supplied to the pillar surface. After the reaction, excessive aminosilane in the structure was removed by rinsing. Also for other modification reactions to be described later, a similar method is preferably employed for introducing the reaction solution.

Then a solution containing fine gold particles of a particle size of 20 - 40 nm was introduced into the capillary to obtain, by an interaction with the amino group, pillars on which the fine gold particles were fixed. Then, in the composite members of the pillars and the fine gold particles, the gold particles were subjected to a surface modification with an ethanol solution of 11-mercaptoundecanoic acid having a thiol group having a high affinity to gold. Thus a carboxyl group was exposed on the gold particle surface. In this state, an aqueous solution of N-hydroxysulfosuccinimide and an aqueous solution of 1-ethyl-3-[3-dimethylaminopropyl]carbodiimide hydrochloride were introduced, thereby a succinimide group was exposed on the surface of the gold particles. Then streptoavidin was bonded to modify the gold particle surface. Then a biotinated anti-troponin antibody was reacted with the gold particle surface to fix said antibody as a capturing component for the target substance.

Fig. 4 is a schematic view of the detecting apparatus of the present example, including a tungsten lamp 401, a collimating lens 403, a reaction area (capillary flow path) 404 in the element and a spectrophotometer 408. The present example employed a tungsten lamp 401 emitting white light, but a laser light may also be employed. A light '402 emitted from the tungsten lamp 401 is converted into a parallel beam by the collimating lens 403, and enters the reaction area 404 of the capturing element, including plural pillars 405 formed on a substrate.' Fine gold particles 406 are fixed on the surface of the pillars 405. The incident light 402 passes through the reaction area 404 in the pillar-containing element, and emerges from the reaction area 404 as an emergent light 407, which enters the spectrophotometer 408. An inlet 409 and an outlet 410 of the element are connected to a solution supply apparatus such as a pump.

As an actual measurement, detection of troponin-T, known as a marker of acute myocardial infarction, is tried. The antigen troponin-T is specifically bonded by the following procedure:
(1) A solution of antigen troponin-T is introduced into the capillary flow path through the inlet 409 shown in Fig. 4, and the element was incubated for 5 minutes; and
(2) The antigen solution was extracted, and the element was rinsed with a phosphate buffer.

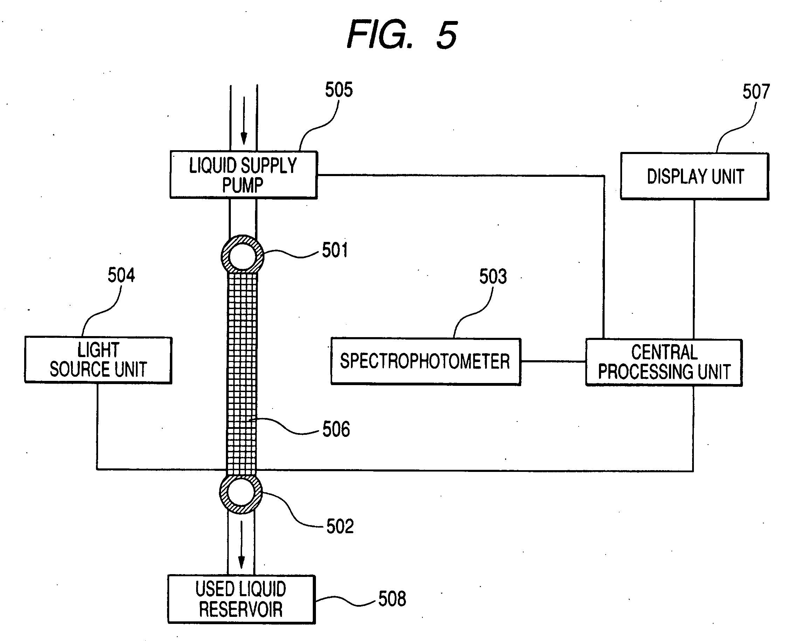

Fig. 5 is a block diagram of the detecting apparatus utilizing the capturing element. The position of the capturing element is so regulated that the reaction region is present on the optical axis of a spectrophotometer 503 and a light source 504. In this state, a spectrum prior to reaction is measured in advance by the spectrophotometer 503. Then a solution supply pump 505 is activated to supply a reaction area 506 of the detecting element with a predetermined amount of a specimen from an inlet 501, thereby causing the fine gold particles to capture the target substance, via the antibody utilizing an antigen-antibody reaction. After the reaction, a spectrum is measured by the spectrophotometer 503 and is compared with the spectrum before the reaction. A difference between the spectra indicates a change in a localized plasmon resonance state of the fine gold particles, caused by the capture of the target substance in the vicinity of the gold particles. The concentration of the target substance is determined from the change in the spectrum, and is displayed on the display unit 507. In Fig. 5, the solution is discharged from an outlet 502 and is stored in a used solution reservoir 508.

The relationship between the change in spectrum and the concentration of the target substance is obtained in advance, utilizing plural standard specimens of known concentrations. A calibration curve is obtained from the relationship, thereby determining a function between the spectrum change and the concentration.. In an actual measurement, such function is utilized to determine the unknown concentration of the target substance, based on the spectrum change. The change in spectrum mentioned above may be a change in a spectral peak at a wavelength where the spectral peak becomes maximum, or a change in a spectral peak shape such as a half-peak width of the spectral peak. Also a change in light intensity at one or plural wavelengths may be utilized.

### (Example 9)

This example shows preparation of a detecting apparatus utilizing the capturing element prepared in Example 4, which was used for detection of PSA, known as a prostate cancer marker. The present example shows a useful application of a detecting element for detecting the presence of a target substance by a fluorescence method.

The pillar surface was subjected to amination with aminosilane, as described in Example 8. Then the amino group on the surface was activated by reaction with a 2% glutaraldehyde solution at 37°C for about 2 hours. After rinsing with deionized water, a phosphoric acid buffer containing an anti-PSA antibody was introduced and allowed to stand at 37°C for 2 hours to form a covalent bond between the active groups on the pillar surface and amino groups contained in the antibody, thereby fixing the anti-PSA antibody 605 as a capturing component.

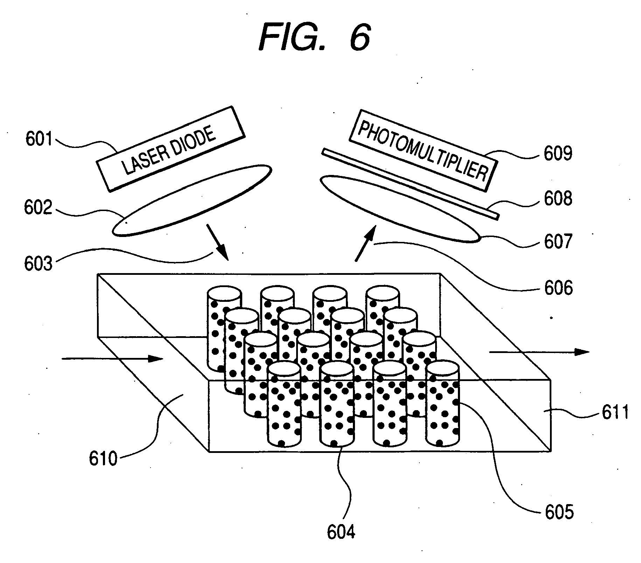

As an actual measurement, detection is tried on PSA, which is known as a prostate cancer marker. The antigen PSA is specifically captured by the following procedure, while a detecting optical system is shown in Fig. 6:
(1) A solution of antigen PSA is introduced from an inlet 610 into a reaction area 604, and incubated for 5 minutes;
(2) The antigen solution is extracted from an outlet 611, and the element is rinsed with a phosphoric acid buffer;
(3) An anti-PSA antibody, fluorescently labeled with Cy5 dye, is introduced from the inlet 610 into the reaction area 604, and incubated for 5 minutes;
(4) The labeled antibody is extracted from the outlet 611, and the element is rinsed with a phosphoric acid buffer; and
(5) The phosphoric acid buffer is introduced to fill the reaction region 604.

After these steps, an exciting light 603 is introduced, from a laser diode 601 and through a collimating lens 602, into the reaction region 604 whereby a fluorescence from the antibody, captured on the pillar surface, can be observed. Based on the intensity of the fluorescence, which will vary depending on the concentration of the fluorescent dye, the concentration of the target substance can be determined. In Fig. 6, a fluorescence (emerging light 606) from the reaction region 604 is measured through a collimating lens 607, a filter 608 and a photomultiplier 609.

### (Example 10)

The present example shows a case of forming pillars on a thin gold film on a sensor substrate, then fixing an anti-troponin antibody as a capturing component on the structure including the pillars, and detecting presence of a target substance by using a surface plasmon resonance (SPR) sensor.

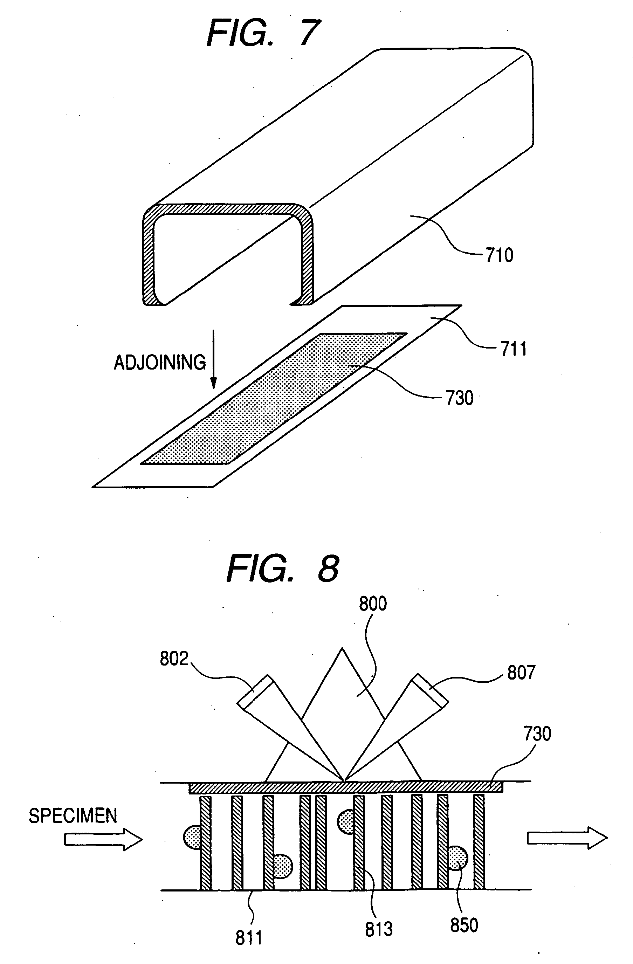

At first, plural pillars are prepared in the inner space by a process similar to that in Example 1, thereby preparing a structure. The hollow member having the inner space preferably has a planar part as shown in Figs. 2A and 2B. The member is prepared, as shown in Fig. 7, by depositing a thin gold film 730 (thickness 50 nm) on a glass substrate 711 and then adjoining a glass flow path 710 which is open on a face thereof.

In the pillar-forming step, the hollow member is preferably allowed to stand in such a position that the gold film-bearing face is located at the top or at the bottom, in order to improve the sensitivity of the SPR sensor. In this manner, a flow path for a specimen, having pillars on the thin gold film, can be obtained.

The pillar surface is subjected to amination by introducing an ethanol solution containing aminosilane into the structure, as explained in Example 8. Then the amino groups on the surface are activated by reaction with a 2% glutaraldehyde solution (37°C, 2 hours). After rinsing with deionized water, a phosphoric acid buffer containing an anti-troponin antibody is introduced and allowed to stand at 37°C for 2 hours, thereby forming a covalent bond between the active groups on the pillar surface and the amino group contained in the antibody, thereby fixing the anti-troponin antibody as a capturing component.

As an actual measurement, detection is tried on troponin-T. The antigen troponin-T is specifically captured by the following procedure. The detecting optical system is an SPR measuring system of Kretschmann configuration as shown in Fig. 8, in which shown are a prism 800, an incident light (polarized light) 802, a reflected light 807, a thin gold film 730 as shownd in Fig. 7, pillars 813 fixing the capturing component on the surface thereof, and a hollow member 811 having an internal structure. By passing a specimen through the hollow member 811, a target substance 850 contained in the specimen is captured on the surface of the pillars 813 fixing the capturing component.

Then the incident (polarized) light 802 is introduced through the prism 800 into the gold film 730, and a change in an angle (resonance angle) of a dark line, generated in the reflected light 807, is recorded as a sensorgram.

A change in the resonance angle, induced by association or dissociation of a molecule to or from the sensor surface, is proportional to a weight change of the captured molecule, and is recorded as a sensorgram, and the concentration of the target substance can be measured by such change.

The pillared structure of the present example, in consideration of a detection range (evanescent region) perpendicular to the gold film of the SPR sensor, can efficiently capture and detect the target substance within the inner space, thus enabling an improvement in the sensitivity.

This application claims priority from Japanese Patent Application No. 2005-079956 filed March 18, 2005 which can be used as further reference.

## Claims

1. A structure, having an opening communicating with an inner space (12,22,32), adapted for separating or capturing a substance introduced from the opening into the inner space, the structure comprising:
a hollow member (11,21,31) having the inner space (12,22,32) and the opening; and
plural pillars (13,33) positioned mutually separately in the inner space,
wherein the pillars are formed of a material containing an inorganic oxide and different in composition from the hollow member,
**characterized in that** said hollow member is an integral hollow member in which a wall surrounding the inner space is formed continuously.

2. A structure according to Claim 1, wherein the inorganic oxide is silica.

3. A structure according to Claim 1, wherein the pillars contain carbon.

4. A separating element, having an opening communicating with an inner space, adapted for separating a target substance contained in a specimen introduced from the opening into the inner space, the element comprising:
a structure according to Claim 1; and
a separating component, provided on a surface of the pillars, capable of having an interaction with the target substance to thereby perform separation of the target substance from the specimen.

5. A separating apparatus, adapted for separating a target substance contained in a specimen, comprising:
a separating element according to Claim 4; and
displacement means for causing fluid displacement within the inner space of the separating element.

6. A separating apparatus according to Claim 5, further comprising detection means (408,503) for detecting a separation state of the target substance.

7. A separating apparatus according to Claim 6, wherein the detection means is capable of optically detecting a separation state of the target substance.

8. A capturing element, adapted for capturing a target substance contained in a specimen, comprising:
a structure according to Claim 1; and
a capturing component; provided on a surface of the pillars, capable of capturing the target substance.

9. A detecting apparatus, adapted for detecting a target substance, comprising:
a capturing element according to claim 8; and
detecting means (408,503) for detecting that the target substance is captured by the capturing element.

10. A detecting apparatus according to claim 9, wherein the detecting means is capable of optically detecting that the target substance is captured.

11. A detecting apparatus according to claim 9, wherein the detecting means utilizes at least a method selected from a fluorescence method, a luminescence method, a light absorption method, a refractive index method, a thermal conductivity method, a thermal lens method, a chemiluminescence method and a plasmon resonance method.

12. A method of separating a target substance contained in a specimen, comprising:
a step of contacting the specimen with a separating element according to claim 4; and
a step of separating the target substance from the specimen, utilizing a physical or chemical interaction of the separating element with the target substance, the interaction being caused to occur in the contacting step.

13. A method of separating a target substance according to claim 12, wherein the target substance is selected from an organic compound and a phosphoric acid compound.

14. A method of detecting a target substance contained in a specimen, comprising:
a step of contacting the specimen with a capturing element according to Claim 8; and
a step of detecting a physical or chemical change resulting from a capture of the target substance by the capturing element.

15. A method of detecting a target substance according to claim 14, wherein the target substance is selected from an organic compound and a phosphoric acid compound.

16. A method of producing a structure provided, in a hollow member (11,21,31) having an inner space (12,22,32), with pillars (13,33) in the inner space, comprising:
a step of preparing a reaction solution dissolving an inorganic oxide precursor and having a composition regulated to form the pillars;
a step of introducing the reaction solution to fill the inner space; and
a step of inducing phase separation and sol-gel transition in the inner space to thereby form the pillars in a direction parallel to the gravitational direction,
**characterized in that** said hollow member is an integral hollow member in which a wall surrounding the inner space is formed continuously.

17. A method of producing a structure according to Claim 16, wherein the inorganic oxide precursor is a metal alcoxide.

18. A method of producing a structure according to Claim 17, wherein the metal alcoxide is silicon alcoxide.

## Patentansprüche

1. Strukturbauteil, das mit einer mit einem Innenraum (12, 22, 32) kommunizierenden Öffnung versehen ist, welche zum Separieren oder Einfangen einer von der Öffnung in den Innenraum eingeführten Substanz ausgelegt ist, wobei das Strukturbauteil umfasst:
ein Hohlglied (11, 21, 31), das den Innenraum (12, 22, 32) und die Öffnung aufweist; und
mehrere Stützen (13, 33), die in dem Innenraum gegeneinander separiert positioniert sind,
wobei die Stützen ausgebildet sind aus einem Material, das ein anorganisches Oxid enthält und in der Zusammensetzung von dem Hohlglied verschieden ist,
**dadurch gekennzeichnet, dass**
das Hohlglied vorliegt als integrales Hohlglied, in welchem eine den Innenraum umgebende Wand kontinuierlich ausgebildet ist.

2. Strukturbauteil nach Anspruch 1, wobei
das anorganische Oxid Siliciumoxid ist.

3. Strukturbauteil nach Anspruch 1, wobei
die Stützen Kohlenstoff enthalten.

4. Separierelement, das mit einer mit einem Innenraum kommunizierenden Öffnung versehen ist, welche ausgelegt ist zum Separieren einer in einer Probe enthaltenen Zielsubstanz, die von der Öffnung in den Innenraum eingeführt wird, wobei das Separierelement umfasst:
ein Strukturbauteil nach Anspruch 1; und
eine Separierkomponente, die vorgesehen ist auf einer Oberfläche der Stützen und für eine Wechselwirkung mit der Zielsubstanz ausgelegt ist, um dadurch eine Separierung der Zielsubstanz von der Probe durchzuführen.

5. Separiervorrichtung, ausgelegt zum Separieren einer in einer Probe enthaltenen Zielsubstanz, umfassend:
ein Separierelement nach Anspruch 4; und
eine Verdrängungseinrichtung zur Veranlassung einer Fluidverdrängung innerhalb des Innenraums des Separierelementes.

6. Separiervorrichtung nach Anspruch 5, ferner umfassend:
eine Nachweiseinrichtung (408, 503) zum Nachweis eines Separierzustandes der Zielsubstanz.

7. Separiervorrichtung nach Anspruch 6, wobei die Nachweiseinrichtung ausgelegt ist für einen optischen Nachweis eines Separierzustandes der Zielsubstanz.

8. Einfangelement, ausgelegt zum Einfangen einer in einer Probe enthaltenen Zielsubstanz, umfassend:
ein Strukturbauteil nach Anspruch 1; und
eine Einfangkomponente, die auf einer Oberfläche der Stützen vorgesehen ist und die Zielsubstanz einzufangen vermag.

9. Nachweisvorrichtung, ausgelegt zum Nachweis einer Zielsubstanz, umfassend:
ein Einfangelement nach Anspruch 8; und
eine Nachweiseinrichtung (408, 503) zum Nachweis, dass die Zielsubstanz vom Einfangelement eingefangen ist.

10. Nachweisvorrichtung nach Anspruch 9, wobei die Nachweiseinrichtung optisch nachzuweisen vermag, dass die Zielsubstanz eingefangen ist.

11. Nachweisvorrichtung nach Anspruch 9, wobei die Nachweiseinrichtung wenigstens eines der Verfahren verwendet, welches ausgewählt ist aus einem Fluoreszenzverfahren, einem Lumineszenzverfahren, einem Lichtabsorptionsverfahren, einem Brechungsindexverfahren, einem Thermoleitfähigkeitsverfahren, einem Thermolinsenverfahren, einem Chemilumineszenzverfahren und einem Plasmon-Resonanzverfahren.

12. Verfahren zum Separieren einer Zielsubstanz, die in einer Probe vorhanden ist, umfassend:
einen Schritt zur Kontaktierung der Probe mit einem Separierelement nach Anspruch 4; und
einen Schritt zur Separierung der Zielsubstanz von der Probe unter Verwendung einer physikalischen oder chemischen Wechselwirkung des Separierelementes mit der Zielsubstanz, wobei die Wechselwirkung veranlasst wird im Kontaktierungsschritt aufzutreten.

13. Verfahren zum Separieren einer Zielsubstanz nach Anspruch 12, wobei die Zielsubstanz ausgewählt wird aus einer organischen Verbindung und einer Phosphorsäurenverbindung.

14. Verfahren zum Nachweisen einer in einer Probe enthaltenen Zielsubstanz, umfassend:
einen Schritt zur Kontaktierung der Probe mit einem Einfangelement nach Anspruch 8; und
einen Schritt zum Nachweis einer physikalischen oder chemischen Änderung, die resultiert von einem Einfang der Zielsubstanz vom Einfangelement.

15. Verfahren zum Nachweisen einer Zielsubstanz nach Anspruch 14, wobei die Zielsubstanz ausgewählt wird aus einer organischen Verbindung und einer Phosphorsäurenverbindung.

16. Verfahren zum Herstellen eines Strukturbauteils, das versehen ist, in einem Hohlglied (11, 21, 31) mit einem Innenraum (12, 22, 32), mit Stützen (13, 33) in dem Innenraum, umfassend:
einen Schritt zur Bereitstellung einer Reaktionslösung, die einen Vorläufer eines anorganischen Oxids auflöst und eine Zusammensetzung aufweist, die zur Bildung der Stützen reguliert ist;
einen Schritt zur Einführung der Reaktionslösung zur Füllung des Innenraums; und
einen Schritt zur Einführung einer Phasentrennung und eines Sol-Gel-Übergangs in dem Innenraum, um dadurch die Stützen in einer Richtung parallel zur Schwerkraftrichtung zu erzeugen,
**dadurch gekennzeichnet, dass**
das Hohlglied ein integrales Hohlglied ist, in welchem eine den Innenraum umgebende Wand kontinuierlich gebildet wird.

17. Verfahren zum Herstellen eines Strukturbauteils nach Anspruch 16, wobei der anorganische Oxidvorläufer ein Metall-Alkoxid ist.

18. Verfahren zum Herstellen eines Strukturbauteils nach Anspruch 17, wobei das Metall-Alkoxid Siliciumalkoxid ist.

## Revendications

1. Structure ayant un orifice communiquant avec un espace intérieur (12, 22, 32), conçue pour séparer ou piéger une substance introduite par l'orifice dans l'espace intérieur, la structure comprenant :
un organe creux (11, 21, 31) comprenant l'espace intérieur (12, 22, 32) et l'orifice ; et
une pluralité de piliers (13, 33) positionnés en étant mutuellement séparés dans l'espace intérieur,
les piliers étant formés d'un matériau contenant un oxyde inorganique et ayant une composition différente de celle de l'organe creux,
**caractérisée en ce que** ledit organe creux est un organe creux intégral dans lequel une paroi entourant l'espace intérieur est formée de manière continue.

2. Structure selon la revendication 1, dans laquelle l'oxyde inorganique est la silice.

3. Structure selon la revendication 1, dans laquelle les piliers contiennent du carbone.

4. Élément de séparation ayant un orifice communiquant avec un espace intérieur, conçu pour séparer une substance cible contenue dans un échantillon introduit par l'orifice dans l'espace intérieur, l'élément comprenant :
une structure selon la revendication 1 ; et
un composant de séparation, disposé sur un surface des piliers, capable d'interagir avec la substance cible pour ainsi effectuer la séparation de la substance cible d'avec l'échantillon.

5. Appareil de séparation, conçu pour séparer une substance cible contenue dans un échantillon, comprenant :
un élément de séparation selon la revendication 4 ; et
un moyen de déplacement pour provoquer un déplacement de fluide dans l'espace intérieur de l'élément de séparation.

6. Appareil de séparation selon la revendication 5, comprenant en outre un moyen de détection (408, 503) destiné à détecter un état de séparation de la substance cible.

7. Appareil de séparation selon la revendication 6, dans lequel le moyen de détection est capable de détecter optiquement un état de séparation de la substance cible.

8. Élément de piégeage, conçu pour piéger une substance cible contenue dans un échantillon, comprenant :
une structure selon la revendication 1 ; et
un composant de piégeage, disposé sur une surface des piliers, capable de piéger la substance cible.

9. Appareil de détection, conçu pour détecter une substance cible, comprenant :
un élément de piégeage selon la revendication 8 ; et
un moyen de détection (408, 503) pour détecter le fait que la substance cible a été piégée par l'élément de piégeage.

10. Appareil de détection selon la revendication 9, dans lequel le moyen de détection est capable de détecter optiquement le fait que la substance cible est piégée.

11. Appareil de détection selon la revendication 9, dans lequel le moyen de détection utilise au moins un procédé sélectionné parmi un procédé utilisant la fluorescence, un procédé utilisant la luminescence, un procédé utilisant l'absorption de la lumière, un procédé utilisant l'indice de réfraction, un procédé utilisant la conductivité thermique, un procédé utilisant une lentille thermique, un procédé utilisant la chimioluminescence et un procédé utilisant la résonance de plasmon.

12. Procédé de séparation d'une substance cible contenue dans un échantillon, comprenant :
une étape consistant à mettre en contact l'échantillon avec un élément de séparation selon la revendication 4 ; et
une étape consistant à séparer la substance cible de l'échantillon en utilisant une interaction physique ou chimique de l'élément de séparation avec la substance cible, l'interaction étant amenée à se produire lors de l'étape de mise en contact.

13. Procédé de séparation d'une substance cible selon la revendication 12, dans lequel la substance cible est sélectionnée parmi un composé organique et un composé d'acide phosphorique.

14. Procédé de détection d'une substance cible contenue dans un échantillon, comprenant :
une étape consistant à mettre en contact l'échantillon avec un élément de piégeage selon la revendication 8 ; et
une étape consistant à détecter une modification physique ou chimique résultant d'un piégeage de la substance cible par l'élément de piégeage.

15. Procédé de détection d'une substance cible selon la revendication 14, dans lequel la substance cible est sélectionnée parmi un composé organique et un composé d'acide phosphorique.

16. Procédé de production d'une structure comprenant, dans un organe creux (11, 21, 31) ayant un espace intérieur (12, 22, 32), des piliers (13, 33) dans l'espace intérieur, comprenant :
une étape consistant à préparer une solution réactionnelle en dissolvant un précurseur d'oxyde inorganique et ayant une composition régulée pour former les piliers ;
une étape consistant à introduire la solution réactionnelle de manière à remplir l'espace intérieur ; et
une étape consistant à induire une séparation de phase et une transition sol-gel dans l'espace intérieur afin de former ainsi les piliers dans une direction parallèle à la direction de la gravitation,
**caractérisé en ce que** ledit organe creux est un organe creux intégral dans lequel une paroi entourant l'espace intérieur est formée de manière continue.

17. Procédé de production d'une structure selon la revendication 16, dans lequel le précurseur d'oxyde inorganique est un alcoxyde de métal.

18. Procédé de production d'une structure selon la revendication 17, dans lequel l'alcoxyde de métal est un alcoxyde de silicium.
